(19)

Europäisches
Patentamt
European
Patent Office
Office européen
des brevets

(11) **EP 1 930 884 A1**

(12) **EUROPEAN PATENT APPLICATION**

(43) Date of publication:
**11.06.2008 Bulletin 2008/24**

(51) Int Cl.:
**G11B 5/84** *(2006.01)* **G11B 5/73** *(2006.01)*
**C23C 14/34** *(2006.01)*

(21) Application number: **07250678.5**

(22) Date of filing: **19.02.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(30) Priority: **05.12.2006 US 633576**

(71) Applicant: **Heraeus, Inc.**
**Chandler AZ 85226 (US)**

(72) Inventors:
• **Das, Anirban**
**Chandler, AZ 85225 (US)**

• **Kennedy, Steven Roger**
**Chandler, AZ 85226 (US)**
• **Racine, Michael Gene**
**Phoenix, AZ 85044 (US)**

(74) Representative: **Hill, Justin John et al**
**McDermott Will & Emery UK LLP**
**7 Bishopsgate**
**London EC2N 3AR (GB)**

Remarks:
Amended claims in accordance with Rule 137(2) EPC.

(54) **Ni-X, NI-Y, and NI-X-Y alloys with or without oxides as sputter targets for perpendicular magnetic recording**

(57) The various embodiments of the present invention generally relate to the deposition of a seedlayer for a magnetic recording medium used for perpendicular magnetic recording (PMR) applications, where the seedlayer provides for grain size refinement and reduced lattice mis-fit for a subsequently deposited underlayer or granular magnetic layer, and where the seedlayer is deposited using a nickel (Ni) alloy based sputter target. The nickel (Ni) alloy can be binary (NiX; Ni-Y) or ternary (Ni-X-Y). In addition, the binary (Ni-X; Ni-Y) or ternary (Ni-X-Y) nickel (Ni) based alloys can be further alloyed with metal oxides, thus forming seedlayer thin films with a granular microstructure containing metallic grains, surrounded by an oxygen rich grain boundary. The nickel-based alloys (with or without metal oxides) of the various exemplary embodiments can be made by powder metallurgical technique or by melt-casting techniques, with or without thermo-mechanical working.

EP 1 930 884 A1

**Description**

**STATEMENT REGARDING FEDERALLY SPONSORED RESEARCH OR DEVELOPMENT**

Not Applicable.

**BACKGROUND**

**Field**

The present invention generally relates to sputter targets and, more particularly, relates to the deposition of a seedlayer for a magnetic recording medium used for perpendicular magnetic recording ("PMR") applications, where the seedlayer provides for grain size refinement and reduced lattice mis-fit for a subsequently deposited underlayer or granular magnetic layer, and where the seedlayer is deposited using nickle (Ni) alloy based sputter target.

Background

The process of direct current ("DC") magnetron sputtering is widely used in a variety of fields to provide thin film material deposition of a precisely controlled thickness and within narrow atomic fraction tolerances on a substrate, for example to coat semiconductors or to form films on surfaces of magnetic recording media. In one common configuration, a racetrack-shaped magnetic field is applied to the sputter target by placing magnets on the backside surface of the target. Electrons are trapped near the sputtering target, improving argon ion production and increasing the sputtering rate. Ions within this plasma collide with a surface of the sputter target causing the sputter target to emit atoms from the sputter target surface. The voltage difference between the cathodic sputter target and an anodic substrate that is to be coated causes the emitted atoms to form the desired film on the surface of the substrate.

Other common approaches to sputtering include conventional co-sputtering, and co-sputtering using a triatron. In the co-sputtering process, multiple independent sputter targets with independent power supplies are positioned within the vacuum chamber and sputtered simultaneously, where the uniformity of the deposited surface is controlled by selectively sputtering one or more of the multiple sputter targets. To sputter a $X1$-$X2$ thin film using conventional co-sputtering, for example, a sputter target comprised of $X1$ would be placed in the vacuum chamber with a sputter target comprised of $X2$, and sputtering would occur on both sputter targets simultaneously. Triatron configuration co-sputtering, on the other hand, uses a single sputter target with multiple independent regions of composition. Adapting the above example to a triatron configuration, a single triatron sputter target would have an region comprised solely of $X1$ and a region comprised solely of $X2$, where both regions would be co-sputtered simultaneously to deposit an $X1$-$X2$ thin film.

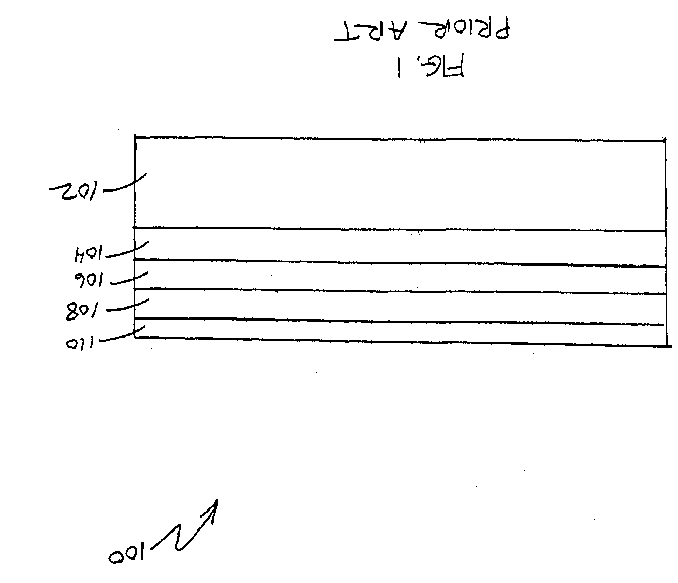

During the production of conventional magnetic recording media, layers of thin films are sequentially sputtered onto a substrate by multiple sputter targets, where each sputter target is comprised of a different material, resulting in the deposition of a thin film "stack." FIG. 1 illustrates typical thin film stack 100 for conventional magnetic recording media. At the base of stack 100 is non-magnetic substrate 102, which is typically aluminum or glass. Seed layer 104 is deposited over substrate 102, where seedlayer 104 forces the shape and orientation of the grain structure of higher layers, and is commonly comprised of tantalum (Ta).

Next, underlayer 106, which often includes one to three discrete layers, is deposited over seedlayer 104, where underlayer 106 is typically very weakly-magnetic, crystalline, and hexagonal close-packed ("HCP"). Underlayer 106 is used to enhance the Co (0002) texture of the subsequently-deposited, cobalt (Co)-based magnetic data-storing granular layer 108 perpendicular to the film plane, leading to a increased perpendicular anisotropy of the media. Magnetic data-storing granular layer 108 is subsequently deposited over underlayer 106, and optional additional layers 110, such as a lubricant layer or carbon (C) overcoat, are deposited over granular layer 108.

Underlayer 106 enhances the crystallographic texturing of the subsequently deposited magnetic data-storing granular layer 108. Furthermore, if magnetic data-storing granular layer 106 is grown epitaxially on top of a refined grain sized, crystalline underlayer, the grain size of magnetic data-storing granular layer 108 is refined as well. Additionally, close lattice matching between underlayer 106 and magnetic data-storing granular layer 108 provides a substantially defect-free interface, potentially reducing contribution to any in-plane magnetization.

The amount of data that can be stored per unit area on a magnetic recording medium is directly related to the metallurgical characteristics and the composition of the magnetic data-storing granular layer and, correspondingly, to the sputter target material from which the magnetic data-storing granular layer is sputtered. In recent years, the magnetic data storage industry has pursued a technology known as 'PMR' (as opposed to conventional 'longitudinal magnetic recording' ("LMR")) to sustain the demand for continuous growth in data storage capacity. PMR has a higher write efficiency using a perpendicular single-pole recording head in combination with a soft underlayer, where bits are recorded perpendicular to the plane of the magnetic recording medium, allowing for a smaller bit size and greater coercivity. In the future, PMR is expected to increase disk coercivity and strengthen disk signal amplitude, translating into superior archival data retention.

In order to achieve a high recording density in PMR media, thermal stability should be high, and media noise performance should be low. One approach to realizing the essential thermal stability and media noise requirements in PMR media is to provide a granular magnetic media with magnetic domains having high magnetocrystalline anisotropy ($K_u$), and to adequately encapsulate a fine grain microstructure in a structurally, magnetically and electrically insulating matrix. Although significant anisotropic energy is already required by conventional LMR, PMR requires a much finer grain microstructure with adequate grain-to grain segregation and negligible cross-talk between the magnetic domains, in order to achieve low media noise performance and high thermal stability.

The inclusion of an oxygen-rich grain boundary region has significantly improved grain refinement and has provided excellent microstructural, magnetic and electrical isolation. In this regard, oxygen (O)-containing magnetic data storing layer 106 often includes at least one CoCrPt-based alloy layer, since oxygen (O) in the grain boundary region forms an amorphous, hard and brittle grain boundary region which confines the grain growth and helps refine the grain size of these oxide-containing granular layers. Other high or low moment CoPt(Cr)(B)-based magnetic data storing layers are also commonly subsequently deposited on this CoCrPt-based granular magnetic layer in order to adjust the saturation magnetization (Ms) commensurate with specified disk head design.

It is therefore considered highly desirable to improve upon known sputter target alloys and compositions to provide for the deposition of a magnetic data-storing granular layer with greater data-storage potential, with particular regard to magnetic data-storing granular layers used in PMR. Specifically, it is highly desirable to provide a sputter target which, when sputtered as a seedlayer, provides increased crystallinity and further grain size refinement to a subsequently deposited underlayer or magnetic data-storing granular layer.

## SUMMARY

The present invention addresses the above-described deficiencies of typical sputter target alloys and compositions. The various embodiments of the present invention generally relate to the deposition of a seedlayer for a magnetic recording medium used for PMR applications, where the seedlayer provides for grain size refinement and reduced lattice mis-fit for a subsequently deposited underlayer or granular magnetic layer, and where the seedlayer is deposited using a nickel (Ni) alloy based sputter target. The present invention also relates to binary and ternary nickel (Ni) alloys as sputter target material which can be reactively sputtered to form magnetic data-storing granular layers having granular media with optimized grain size and improved grain-to-grain separation.

According to at least one exemplary embodiment of the present invention, a magnetic recording medium has a substrate, with a seedlayer deposited over the substrate. The seedlayer is comprised of nickel (Ni), an alloying element (X), and metal oxide. An underlayer is deposited over the seedlayer, and a magnetic data-storing granular layer deposited over the underlayer. The solubility of the alloying element in a face-centered cubic nickel (Ni) phase does not exceed 50 atomic percent at room temperature or at elevated temperatures. In addition, the alloying element (X) has a mass susceptibility of less than or equal to $1.5 \times 10^{-7} \frac{m^3}{kg}$.

The alloying element is selected from boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th).

The alloying element (X) in the crystalline nickel (Ni) alloy based seedlayer promotes refined grain size. Just as the refined grain size of the crystalline underlayer helps reduce the grain size reduction of the subsequently deposited granular magnetic layer, a similar effect is realized by the underlayer if the underlayer is subsequently deposited epitaxially on top of the reduced grain size, crystalline nickel alloy (Ni-X) based seedlayer. Various exemplary embodiments of the present invention provide for a promotion of grain size refinement by alloying nickel (Ni) with an element (X) which acts as a grain size refiner in the crystalline nickel (Ni) alloy based seedlayer film, so the alloying element has little or no solubility in face-centered cubic nickel (Ni) phase at room temperature, such that the alloying element forms the amorphous grain boundary region in the nickel (Ni) alloy based seedlayer film and helps in grain size reduction by confining any further grain growth during processing.

In at least one exemplary embodiment of the invention, a sputter target has nickel (Ni), and an alloying element (X) selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th), with the alloying element present in the sputter target in an amount exceeding a solid solubility limit of the alloying element in face-centered cubic (FCC) phase nickel (Ni) at or above room temperature. The sputter target also has metal oxide.

According to at least one exemplary embodiment of the present invention, a magnetic recording medium has a substrate, and a seedlayer deposited over the substrate. The seedlayer comprised of nickel (Ni), an alloying element (Y), and metal oxide. An underlayer deposited over the seedlayer, and a magnetic data-storing granular layer deposited over the underlayer. Preferably, the alloying element (Y) is added to nickel (Ni) at less than or equal to 10 atomic percent of its maximum solubility limit at or above room temperature. The alloying element (Y) is soluble in nickel (Ni) at room temperature or at elevated temperatures. Also, the alloying element has a mass susceptibility of less than or equal to

$$1.5 \times 10^{-7} \frac{m^3}{kg}$$ . In addition, the alloying element has an atomic radius greater than 1.24 Å.

The alloying element (Y) is selected from aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb).

Due to the symmetry of the (111) plane of the face-centered cubic (FCC) nickel (Ni), the present invention provides for the reduction of lattice mis-fit of crystalline underlayers, such as ruthenium (Ru) or ruthenium (Ru)-based underlayers or underlayers composed of different base metals, and nickel alloy (Ni-Y) based seedlayers by alloying the crystalline seedlayer of nickel (Ni) with elements (Y) which are soluble in at room temperature or at higher temperatures. The (0002) orientation in the ruthenium (Ru) or ruthenium (Ru)-based alloys underlayer also promotes strong (0002) texture growth in the granular magnetic recording layer. These alloying elements can form solid solutions with nickel (Ni) at room temperature or at elevated temperatures, and thus accordingly modify the in-plane lattice parameter of nickel (Ni), thereby reducing the lattice mis-fit.

In at least one embodiment of the present invention, a sputter target has nickel (Ni), an alloying element (Y) selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb), where the alloying element present in the sputter target in an amount exceeding a solid solubility limit of the alloying element in face-centered cubic (FCC) phase nickel (Ni) at or above room temperature. The sputter target also has metal oxide.

According to at least one embodiment of the present invention, a magnetic recording medium has a substrate, with a seedlayer deposited over the substrate. The seedlayer is comprised of nickel (Ni), a first alloying element (X), and a second alloying element (Y). An underlayer is deposited over the seedlayer, with a magnetic data-storing granular layer deposited over the underlayer. The solubility of the first alloying element (X) in a face-centered cubic nickel (Ni) phase does not exceed 50 atomic percent at room temperature or at elevated temperatures. The second alloying element (Y) is added to nickel (Ni) at less than or equal to 10 atomic percent of its maximum solubility limit at or above room temperature, and has an atomic radius greater than 1.24 Å. Moreover, the first alloying element and the second alloying element have a mass susceptibility of less than or equal to $1.5 \times 10^{-7} \frac{m^3}{kg}$ . Accordingly, a ternary nickel alloy (Ni-X-Y) can be formed comprising both grain size reforming elements (X) and soluble elements (Y) for reducing lattice mismatch and eliminating interface stresses. In various exemplary embodiments, the seedlayer is further comprised of metal oxide.

The first alloying element is selected from boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th). The second alloying element is selected from aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb).

In at least one embodiment of the present invention, a sputter target has a sputter target has nickel (Ni), and a first alloying element selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th), with the first alloying element present in the sputter target in an amount exceeding a solid solubility limit of the alloying element in face-centered cubic (FCC) phase nickel (Ni) at or above room temperature. The sputter target can further include a second alloying element, where the second alloying element the second alloying element having a solid solubility limit in face-centered cubic (FCC) phase nickel (Ni) of less than or equal to 10 atomic percent at or above room temperature, the second alloying element having a mass susceptibility of less than or equal to $1.5 \times 10^{-7} \frac{m^3}{kg}$ , with the second alloying element present in the sputter target in an amount not exceeding the solid solubility limit of the second alloying element. The second alloying element is selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (Tl), and lead (Pb), where the second alloying element present in the sputter target in an amount exceeding a solid solubility limit of the alloying element in face-centered cubic (FCC) phase nickel (Ni) at or above room temperature. In various exemplary embodiments of the invention, the sputter target is further comprised of metal oxide.

At least one exemplary embodiment of the present invention relates to a method of manufacturing a magnetic recording medium. At least a first seedlayer is sputtered over a substrate from a first sputter target, where the first sputter target is comprised of nickel (Ni) and an alloying element (X), wherein solubility of the alloying element in a face-centered cubic nickel (Ni) phase does not exceed 50 atomic percent at or above room temperature, and where the alloying element has a mass susceptibility of less than or equal to $1.5 \times 10^{-7} \frac{m^3}{kg}$. The first sputter target is further comprised of metal oxide. At least a first underlayer is sputtered over the first seedlayer from a second sputter target. In addition, at least a first magnetic data-storing granular layer is sputtered over the first underlayer from a third sputter target.

At least one exemplary embodiment of the present invention relates to a method of manufacturing a magnetic recording medium. At least a first seedlayer is sputtered over a substrate from a first sputter target, where the first sputter target is comprised of nickel (Ni) and an alloying element (Y), where solubility of the alloying element in a face-centered cubic nickel (Ni) phase is less than or equal to 10 atomic percent at or above room temperature, and where the alloying element has a mass susceptibility of less than or equal to $1.5 \times 10^{-7} \frac{m^3}{kg}$. The sputter target is further comprised of metal oxide. At least a first underlayer is sputtered over the first seedlayer from a second sputter target. In addition, at least a first magnetic data-storing granular layer is sputtered over the first underlayer from a third sputter target.

At least one exemplary embodiment of the present invention relates to a method of manufacturing a magnetic recording medium. At least a first seedlayer is sputtered over a substrate from a first sputter target, wherein the first sputter target is comprised of nickel (Ni) and a first alloying element and a second alloying element, where the solubility of the first alloying element in a face-centered cubic nickel (Ni) phase does not exceed 50 atomic percent at room temperature, where the solubility of the second alloying element in a face-centered cubic nickel (Ni) phase is less than or equal to 10 atomic percent of its maximum solubility limit at or above room temperature, and where the first and second alloying elements have a mass susceptibility of less than or equal to $1.5 \times 10^{-7} \frac{m^3}{kg}$. At least a first underlayer is sputtered over the first seedlayer from a second sputter target. Also, at least a first magnetic data-storing granular layer is sputtered over the first underlayer from a third sputter target. In various exemplary embodiments, the first sputter target may be further comprised on metal oxide.

The seedlayer or sputter targets of various exemplary embodiments may have metal oxide. The metal oxide can have at least one metal element that is silicon (Si), aluminum (Al), titanium (Ti), niobium (Nb), tantalum (Ta), zirconium (Zr), hafnium (Hf), tungsten (W), or any lanthanide, or any combination thereof. The at least one metal element of the metal oxide can have a reduction potential more negative than nickel (Ni). An advantage of alloying the binary (Ni-X; Ni-Y) or ternary (Ni-X-Y) nickel based alloys with metal oxides is that the resulting deposited film or sputter target has a granular alloy microstructure with oxygen rich grain boundaries to provide further grain size refinement.

Advantages of the various exemplary embodiments described above include, but are not limited to, providing for grain size refinement and reduced lattice mis-fit for a subsequently deposited underlayer or granular magnetic layer, as well as improving the Signal-to-Noise Ratio (SNR) and increasing the magnetocrystalline anisotropy $K_u$ in the media stack for PMR. The various embodiments described above also advantageously improve sputter targets.

It is understood that other embodiments of the present invention will become readily apparent to those skilled in the art from the following detailed description, wherein it is shown and described only various embodiments of the invention by way of illustration. As will be realized, the invention is capable of other and different embodiments and its several details are capable of modification in various other respects, all without departing from the spirit and scope of the present invention. Accordingly, the drawings and detailed description are to be regarded as illustrative in nature and not as restrictive.

**BRIEF DESCRIPTION OF THE DRAWINGS**

Referring now to the drawings in which like reference numbers represent corresponding parts throughout:

FIG. 1 illustrates a typical prior art thin film stack for conventional PMR media;

FIG. 2 illustrates a thin film stack for PMR media according to various exemplary embodiments of the present invention;

FIG. 3 illustrates a sputter target according to various embodiments of the present invention;

FIG. 4 illustrates an exemplary lattice misfit diagram of an face-centered Cubic (111) Ni plane and a Ru (0002) plane; and

FIG. 5 illustrates a flowchart depicting a method for manufacturing a magnetic recording medium according to various exemplary embodiments of the present invention.

## DETAILED DESCRIPTION

The various embodiments of the present invention generally relate to the deposition of a seedlayer for a magnetic recording medium used for perpendicular magnetic recording (PMR) applications, where the seedlayer provides for grain size refinement and reduced lattice mis-fit for a subsequently deposited underlayer or granular magnetic layer, and where the seedlayer is deposited using a nickel (Ni) alloy based sputter target. The nickel (Ni) alloy can be binary (Ni-X; Ni-Y) or ternary (Ni-X-Y). In addition, the binary (Ni-X; Ni-Y) alloys are further alloyed with metal oxide. The ternary (Ni-X-Y) nickel (Ni) based alloys may, in various embodiments, be further alloyed with metal oxides. The nickel (Ni) alloys with metal oxide form seedlayer thin films with a granular microstructure containing metallic grains, surrounded by an oxygen rich grain boundary. The nickel-based alloys (with or without metal oxides) of the various exemplary embodiments can be made by powder metallurgical technique or by melt-casting techniques, with or without thermo-mechanical working.

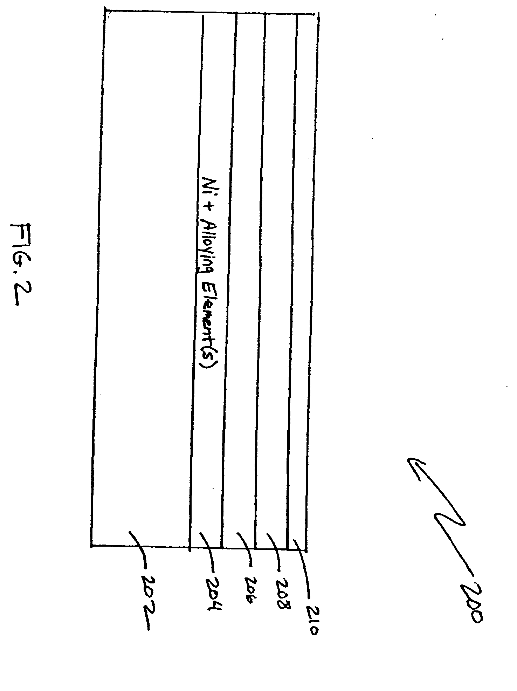

FIG. 2 illustrates an exemplary thin film stack in accordance with various embodiments of the present invention. Magnetic recording medium 200 includes substrate 202 and seedlayer 204 deposited over substrate 202, seedlayer 204 comprised of nickel (Ni) and an alloying element. While omitted from the illustration in FIG. 2, in various exemplary embodiments, at least one layer may be deposited between substrate 202 and seedlayer 204. The at least one layer may be an underlayer, anti-ferromagnetic layer, or other type of layer that may comprise either magnetic or non-magnetic materials.

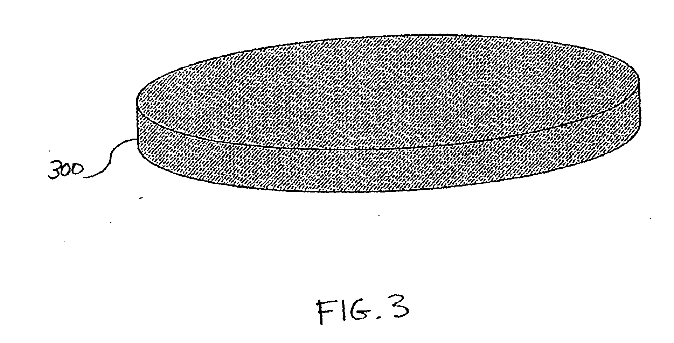

In various embodiments of the invention, seedlayer 204 is comprised of nickel (Ni), a first alloying element, and a second alloying element. The nickel (Ni) based alloy of seedlayer 204 can be further alloyed with metal oxides, thus forming seedlayer thin films with a granular microstructure containing metallic grains, surrounded by an oxygen rich grain boundary. The metal oxide can have at least one metal element that is silicon (Si), aluminum (Al), titanium (Ti), niobium (Nb), tantalum (Ta), zirconium (Zr), hafnium (Hf), tungsten (W), or any lanthanide, or any combination thereof. Moreover, seedlayer 204 can be sputter deposited from a sputter target such as a sputter target 300 in FIG. 3 according to various embodiments of the present invention.

The magnetic recording medium also includes underlayer 206 deposited over seedlayer 204, and magnetic data-storing granular layer 208 deposited over underlayer 206. Close lattice matching between underlayer 206 and magnetic data-storing granular layer 208 ensures almost a defect free interface and thus can potentially reduce contribution to any in-plane magnetization. Underlayer 206 is comprised of ruthenium (Ru) or a ruthenium (Ru)-based alloy, although other base metals typically used in the art may be used in conjunction with or instead of ruthenium (Ru). In various embodiments, underlayer 206 may have a crystalline structure. For example, underlayer 206 may have a hexagonal close-pack structure. Additionally, in various exemplary embodiments of the invention, underlayer 206 is weakly magnetic or non-magnetic in nature. Underlayer 206 not only enhances the crystallographic texturing of magnetic data-storing granular layer 208, but also can help in the grain size refinement of magnetic data-storing granular layer 208, if magnetic data-storing granular layer 208 is grown epitaxially on top of underlayer 206 with refined grain size.

Magnetic data-storing granular layer 208 is deposited over underlayer 206. Magnetic data-storing granular layer 208 can be CoCrPt, and, in various exemplary embodiments, can further comprise oxygen (O). Additionally, a lubricant layer or carbon overcoat layer may be deposited above magnetic data-storing granular layer 208 (or saturation magnetization layer 210, if it is included). The lubricant layer or carbon overcoat layer may serve as a protectant. Furthermore, additional magnetic or non-magnetic layers may be deposited above magnetic data-storing granular layer 208.

The exemplary magnetic recording medium 200 of FIG. 2 additionally illustrates saturation magnetization adjustment layer 210. Saturation magnetization adjustment layer 210 can be CoPt, or CoPt can be further alloyed with chromium (Cr) or boron (B), or any combination thereof. In various embodiments of the present invention, saturation magnetization adjustment layer 210 can be omitted.

## Ni-X

According to at least one exemplary embodiment of the present invention, a binary (Ni-X) alloy can be utilized to promote grain size refinement in the crystalline underlayer in a magnetic recording medium. The magnetic recording medium has a substrate, with a seedlayer deposited over the substrate. The seedlayer is comprised of nickel (Ni), an alloying element (X), and a metal oxide. An underlayer is deposited over the seedlayer, and a magnetic data-storing granular layer deposited over the underlayer. The solubility of the alloying element in a face-centered cubic nickel (Ni) phase does not exceed 50 atomic percent at room temperature or at elevated temperatures. In addition, the alloying element has a mass susceptibility of less than or equal to $1.5 \times 10^{-7} \frac{m^3}{kg}$.

The alloying element (X) is selected from boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th). The metal oxide can have at least one metal element that is silicon (Si), aluminum (Al), titanium (Ti), niobium (Nb), tantalum (Ta), zirconium (Zr), hafnium (Hf), tungsten (W), or any lanthanide, or any combination thereof. The at least one metal element of the metal oxide can have a reduction potential more negative than nickel (Ni). An advantage of the nickel (Ni) alloy (Ni-X) with metal oxide is that the resulting deposited film or sputter target has a granular alloy microstructure with oxygen rich grain boundaries to provide further grain size refinement.

The alloying element (X) in the crystalline nickel (Ni) alloy based seedlayer promotes refined grain size. Just as the refined grain size of the crystalline underlayer helps reduce the grain size reduction of the subsequently deposited granular magnetic layer, a similar effect is realized by the underlayer if the underlayer is subsequently deposited epitaxially on top of the reduced grain size, binary crystalline nickel alloy (Ni-X) based seedlayer with metal oxide. Various exemplary embodiments of the present invention provide for a promotion of grain size refinement by alloying nickel (Ni) with an element (X) which acts as a grain size refiner in the crystalline nickel (Ni) alloy based seedlayer film, so the alloying element has little or no solubility in face-centered cubic nickel (Ni) phase at room temperature, such that the alloying element forms the amorphous grain boundary region in the nickel (Ni) alloy based seedlayer film and helps in grain size reduction by confining any further grain growth during processing.

The alloying element (X) is non-magnetic or weakly magnetic in nature, with a mass susceptibility of less than or equal to $1.5 \times 10^{-7} \frac{m^3}{kg}$. Table 1, below, provides a list of alloying elements (X) which can be alloyed with nickel (Ni) to form an enhanced alloy (Ni-X) which provides for grain size reduction in the seedlayer film, although other elements which meet these characteristics may also be used as well.

**Table 1: Alloying Elements Which Provide For Grain Size Refinement**

| Element | Atomic Number | Atomic Radius | Structure | Mass Susceptibility ($10^{-8}$ m³/kg) | Room Temperature(RT), Solubility in Nickel (Ni) |
|---|---|---|---|---|---|
| B | 5 | 0.97 Å | Rhombohedral | -0.87 | Insoluble |
| C | 6 | 0.77 Å | Diamond Cubic | -0.62 | 1326C (2.7%); Insoluble (RT) |
| Mn | 25 | 1.35 Å | Cubic | 12.2 | Insoluble |
| Cu | 29 | 1.28 Å | Face-Centered Cubic | -0.1 | Insoluble |
| Y | 39 | 1.81 Å | Hexagonal Close-Pack | 6.66 | Insoluble |
| Zr | 40 | 1.60 Å | Hexagonal Close-Pack | 1.66 | 1170C (1.78%); Insoluble (RT) |
| Rh | 45 | 1.34 Å | Face-Centered Cubic | 1.32 | Insoluble |
| Ag | 47 | 1.44 Å | Face-Centered Cubic | -0.23 | 1435C(3%); Insoluble (RT) |
| Cd | 48 | 1.52 Å | Hexagonal Close-Pack | -0.23 | Insoluble |

(continued)

| Element | Atomic Number | Atomic Radius | Structure | Mass Susceptibility (10$^{-8}$ m$^3$/kg) | Room Temperature(RT), Solubility in Nickel (Ni) |
|---------|---------------|---------------|-----------|------------------------------------------|-------------------------------------------------|
| Yb | 70 | 1.93 Å | Face-Centered Cubic | 0.59 | Insoluble |
| Hf | 72 | 1.59 Å | Hexagonal Close-Pack | 0.53 | 1190C (1%); Insoluble (RT) |
| Ir | 77 | 1.35 Å | Face-Centered Cubic | 0.23 | Insoluble |
| Pt | 78 | 1.38 Å | Face-Centered Cubic | 1.22 | Insoluble |
| Au | 79 | 1.44 Å | Face-Centered Cubic | -0.18 | Insoluble |
| Bi | 83 | 1.75 Å | Monoclinic | -1.70 | Insoluble |
| Th | 90 | 1.80 Å | Face-Centered Cubic | 0.53 | Insoluble |

The alloying element (X) can be added anything in excess of its maximum solubility limit (room temperature or higher) and added to be greater than or equal to 50 atomic percent. The alloying element (X) can be added in high atomic percentages, such as 50% in the nickel (Ni) based alloy, although higher or lower atomic percentages can also be used as desired. The alloying element can also be added in excess of its maximum solubility limit, at room temperature or higher temperatures. "Higher" than room temperature or "elevated" over room temperature means any temperature over room temperature, which is ordinarily considered approximately 20-23 °C, or 68-73 °F. Example temperatures which would be higher than or elevated over room temperature would be 25 °C, 100 °C, 1000 °C, 2500 °C, or 5000 °C.

Nickel (Ni), the alloying element (X), and metal oxide can used in a sputter target such as sputter target 300 of FIG. 3. The alloying element (X) present in the sputter target is in an amount exceeding a solid solubility limit of the alloying element in face-centered cubic (FCC) phase nickel (Ni) at or above room temperature. In addition, the alloying element (X) can be present in the sputter target in an amount no more than 50 atomic percent greater than the solid solubility limit of the alloying element in face-centered cubic (FCC) phase nickel (Ni) at or above room temperature.

Moreover, the alloying element (X) has a mass susceptibility of less than or equal to $1.5 \times 10^{-7} \frac{m^3}{kg}$ .

**Ni-Y**

According to at least one exemplary embodiment of the present invention, an alloying element (Y) of a binary seedlayer alloy (Ni-Y) further having metal oxide can reduce lattice mis-fit for a magnetic recording medium. The magnetic recording medium has a substrate, and a seedlayer deposited over the substrate. The seedlayer comprised of nickel (Ni), an alloying element (Y), and a metal oxide. An underlayer deposited over the seedlayer, and a magnetic data-storing granular layer deposited over the underlayer. Preferably, the alloying element (Y) is added to nickel (Ni) at less than or equal to 10 atomic percent of its maximum solubility limit at or above room temperature. The alloying element (Y) is soluble in nickel (Ni) at room temperature or at elevated temperatures. Also, the alloying element has a mass susceptibility of less than or equal to $1.5 \times 10^{-7} \frac{m^3}{kg}$ . In addition, the alloying element has an atomic radius greater than 1.24 Å.

The alloying element (Y) is selected from aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb). The metal oxide can have at least one metal element that is silicon (Si), aluminum (Al), titanium (Ti), niobium (Nb), tantalum (Ta), zirconium (Zr), hafnium (Hf), tungsten (W), or any lanthanide, or any combination thereof. The at least one metal element of the metal oxide can have a reduction potential more negative than nickel (Ni). An advantage of the nickel (Ni) alloy (Ni-y) with metal oxide is that the resulting deposited film or sputter target has a granular alloy microstructure with oxygen rich grain boundaries to provide further grain size refinement.

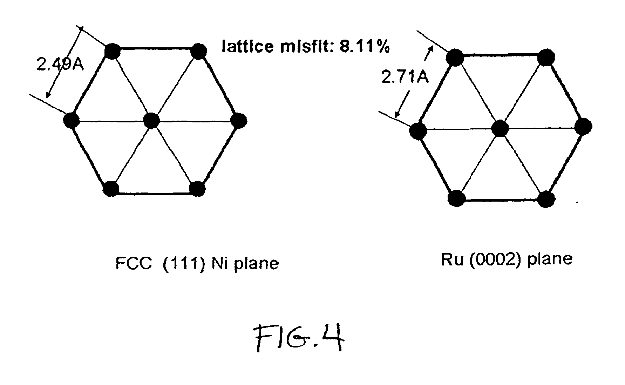

Due to the symmetry of the FCC (111) plane of nickel with the HCP (0002) plane of ruthenium (Ru), the present invention provides for the reduction of lattice mis-fit of crystalline underlayers, such as ruthenium (Ru) or ruthenium (Ru)-based underlayers or underlayers composed of different base metals, and nickel (Ni) alloy based seedlayers by alloying the crystalline seedlayer with nickel (Ni) and elements (Y) which are soluble in nickel (Ni) at room temperature or at elevated temperatures. The strong (0002) orientation in the ruthenium (Ru) or ruthenium (Ru) alloy based underlayer also promotes strong (0002) texture growth in the granular magnetic recording layer. As illustrated by way of example in FIG. 4, pure nickel (Ni) and ruthenium (Ru) films with their respective crystallographic orientations show a lattice misfit of 8.11 %. These alloying elements (Y) form solid solutions with nickel (Ni) at room temperature or at elevated temperatures, and thus accordingly modify the in-plane lattice parameter of nickel (Ni), thereby reducing the lattice mis-fit. The alloying element (Y) in the nickel-based alloy (Ni-Y) with metal oxide has some solid solubility in nickel (Ni) at room temperature or at elevated temperatures, so that the alloying element (Y) forms a substitutional solid solution with nickel (Ni) and affects its in-plane, a-lattice parameter. Additionally, the alloying element is non-magnetic or weakly-magnetic in nature, with a mass susceptibility of less than or equal to $1.5 \times 10^{-7} \frac{m^3}{kg}$. Since the in-plane lattice parameter for nickel (Ni) is higher than that of ruthenium (Ru), the alloying element has an atomic radius greater than that of 1.24 Å, which is the atomic radius of nickel (Ni). Based on the above criteria, Table 2 (below) provides a list of alloying elements which can be alloyed with nickel (Ni) to form alloys (Ni-Y), which are further alloyed with metal oxide, and which provide for potential lattice matching with the subsequently deposited underlayer, further enhancing crystallinity.

**Table 2: Alloying Elements that Reduce Lattice Misfit**

| Element | Atomic Number | Atomic Radius | Structure | Mass Susceptibility ($10^{-8}$ m³/kg) | RT Solubility in Nickel (Ni) |
|---|---|---|---|---|---|
| Al | 13 | 1.43 Å | Face-Centered Cubic | 0.82 | 1385C (21.2%); 400C (7%) |
| Si | 14 | 1.32 Å | Diamond Cubic | -0.16 | 1143C (15.8%); 700C (10%) |
| Ti | 22 | 1.47 Å | Hexagonal Close-Pack | 4.21 | 1304C (13.9%); 800C (7%) |
| V | 23 | 1.36 Å | Body-Centered Cubic | 6.28 | 1202C (43%); 200C (8%) |
| Zn | 30 | 1.37.Å | Hexagonal Close-Pack | -0.20 | 1040C (48.3%); RT (20%) |
| Ge | 32 | 1.37 Å | Diamond Cubic | | 1124C (12%); 200C (9.5%) |
| Nb | 41 | 1.47 Å | Body-Centered Cubic | 2.81 | 1282C (14%); 400C (3%) |
| Mo | 42 | 1.40 Å | Body-Centered Cubic | 1.17 | 1317C (28%); 700C (17.5%) |
| Ru | 44 | 1.34 Å | Hexagonal Close-Pack | 0.54 | 1550C (34.5%); 600C (4%) |
| Ta | 73 | 1.47 Å | Body-Centered Cubic | 1.07 | 1330C (14%); 800C (3%) |
| W | 74 | 1.41 Å | Body-Centered Cubic | 0.39 | 1495C (17%); RT (12%) |
| Re | 75 | 1.41 Å | Hexagonal Close-Pack | 0.46 | 1620C (17.4%); 600C (12%) |

(continued)

| Element | Atomic Number | Atomic Radius | Structure | Mass Susceptibility ($10^{-8}$ m³/kg) | RT Solubility in Nickel (Ni) |
|---------|---------------|---------------|-----------|------------------|----------------------------|
| Os | 76 | 1.38 Å | Hexagonal Close-Pack | 0.06 | 1464C (11.7%); 600C (6%) |
| Tl | 81 | 1.71 Å | Hexagonal Close-Pack | -0.30 | 1387C (2.5%); 200C (2%) |
| Pb | 82 | 1.73 Å | Face-Centered Cubic | -0.15 | 1340C (11.5%); 200C/RT (1.5%) |

The preferred elements to alloy with nickel (Ni) to form a nickel-based alloy (Ni-Y) would be aluminum (Al), titanium (Ti), vanadium (V), germanium (Ge), niobium (Nb), molybdenum (Mo), tantalum (Ta), tungsten (W), or rhenium (Re), as these elements have an atomic radius greater than 1.35 Å and a solubility of greater than or equal to three atomic percent. Other desirable elements to be used in forming the nickel-based (Ni-Y) alloy include silicon (Si) or ruthenium (Ru), as these element have an atomic radius of 1.30-1.35 Å, and a solubility of three atomic percent. Nickel can also be alloyed with zinc (Zn), osmium (Os), thallium (Tl) or lead (Pb) to reduce lattice mis-fit.

The alloying element (Y) in the nickel alloy (Ni-Y) based seedlayer with metal oxide can be added within the solubility range or in excess of the element's highest solubility limit for room temperature or above, in nickel (Ni). If added significantly in excess (as high as 10 atomic percent) of its maximum solubility limit in nickel (Ni), the alloy element (Y) can act both as an additive to reduce lattice mismatch and as a grain size reformer.

Nickel (Ni), the alloying element (Y), and metal oxide can used in a sputter target such as sputter target 300 of FIG. 3. The alloying element (Y) is present in the sputter target in an amount exceeding a solid solubility limit of the alloying element in face-centered cubic (FCC) phase nickel (Ni) at or above room temperature. The alloying element (Y) of the sputter target has a mass susceptibility of less than or equal to $1.5 \times 10^{-7} \dfrac{m^3}{kg}$ . In addition , the alloying element (Y) is present in the sputter target in an amount no more than 10 atomic percent than the solid solubility limit of the alloying element in face-centered cubic (FCC) phase nickel (Ni) at or above room temperature.

### Ni-X-Y

In various embodiments of the present invention, a ternary nickel (Ni) based alloy (Ni-X-Y) composition may be formed, where a first alloying element (X) refines grain size because of its insolubility (or limited solid solubility at less than 10 atomic percent) in nickel (Ni) and added above its maximum solubility limit. A second alloying element (Y) can be added within the solubility range or in excess of the second alloying element's (Y) high solubility limit for room temperature or above, in nickel (Ni). Additionally, the alloying elements (X or Y) are non-magnetic or weakly magnetic in nature, with a mass susceptibility of less than or equal to $1.5 \times 10^{-7} \dfrac{m^3}{kg}$ . Based on the above-identified citeria, Table 3 (below) provides a list of alloying elements which can be alloyed with nickel (Ni) to form ternary alloys (Ni-X-Y), where the first alloying element (X) provides for grain size reduction in the seedlayer film and the second alloying element (Y) provides enhanced lattice matching with the subsequently deposited underlayer, further enhancing crystallinity.

**Table 3: Alloying Elements for Grain Size Refinement and Lattice Matching**

| Grain Size Refiner (Higher than its Highest Solubility at Room Temperature and Higher) | Elements for Lattice Matching (Up to its Highest Solubility Limit at Room Temperature abd Higher) |
|---|---|
| B | Al |
| C | Si |
| Mn | Ti |
| Cu | V |

(continued)

| Grain Size Refiner<br>(Higher than its Highest Solubility at Room Temperature and Higher) | Elements for Lattice Matching<br>(Up to its Highest Solubility Limit at Room Temperature abd Higher) |
|---|---|
| Y | Cr |
| Zr | Zn |
| Rh | Ge |
| Ag | Nb |
| Cd | Mo |
| Yb | Ru |
| Hf | Ta |
| Ir | W |
| Pt | Re |
| Au | Os |
| Bi | Tl |
| Th | Pb |

According to at least one embodiment of the present invention, a magnetic recording medium has a substrate, with a seedlayer deposited over the substrate. The seedlayer is comprised of nickel (Ni) and a first alloying element (X) and a second alloying element (Y). An underlayer is deposited over the seedlayer, with a magnetic data-storing granular layer deposited over the underlayer. The solubility of the first alloying element (X) in a face-centered cubic nickel (Ni) phase does not exceed 50 atomic percent at room temperature or at elevated temperatures. The second alloying element (Y) is added to nickel (Ni) at less than or equal to 10 atomic percent of its maximum solubility limit at or above room temperature, and has an atomic radius greater than 1.24 Å. Moreover, the first alloying element and the second alloying element have a mass susceptibility of less than or equal to $1.5 \times 10^{-7} \; \frac{m^3}{kg}$. Accordingly, a ternary nickel alloy (Ni-X-Y) can be formed comprising both grain size reforming elements (X) and soluble elements (Y) for reducing lattice mismatch and eliminating interface stresses.

The first alloying element is selected from boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th). The second alloying element is selected from aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (Tl), and lead (Pb).

Nickel (Ni) and the alloying elements (X and Y) can used in a sputter target such as sputter target 300 of FIG. 3. The alloying element (X) present in the sputter target is in an amount exceeding a solid solubility limit of the alloying element in face-centered cubic (FCC) phase nickel (Ni) at or above room temperature. In addition, the alloying element (X) can be present in the sputter target in an amount no more than 50 atomic percent greater than the solid solubility limit of the alloying element in face-centered cubic (FCC) phase nickel (Ni) at or above room temperature. Moreover, the alloying element (X) has a mass susceptibility of less than or equal to $1.5 \times 10^{-7} \; \frac{m^3}{kg}$. The alloying element (Y) is present in the sputter target in an amount exceeding a solid solubility limit of the alloying element in face-centered cubic (FCC) phase nickel (Ni) at or above room temperature. The alloying element (Y) of the sputter target has a mass susceptibility of less than or equal to $1.5 \times 10^{-7} \; \frac{m^3}{kg}$. In addition, the alloying element (Y) is present in the sputter target in an amount less than or equal to 10 atomic percent greater than the solid solubility limit of the alloying element in face-centered cubic (FCC) phase nickel (Ni) at or above room temperature.

The above-described ternary (Ni-X-Y) alloys for magnetic recording medium or sputter targets can be further alloyed with metal oxides in various embodiments of the invetion, thus forming seedlayer thin films with a granular microstructure containing metallic grains, surrounded by an oxygen rich grain boundary. The metal oxide can have at least one metal element that is silicon (Si), aluminum (Al), titanium (Ti), niobium (Nb), tantalum (Ta), zirconium (Zr), hafnium (Hf), tungsten (W), or any lanthanide, or any combination thereof. The at least one metal element of the metal oxide can have a reduction potential more negative than nickel (Ni), which is -0.257 V.

**Manufacturing a Recording Medium**

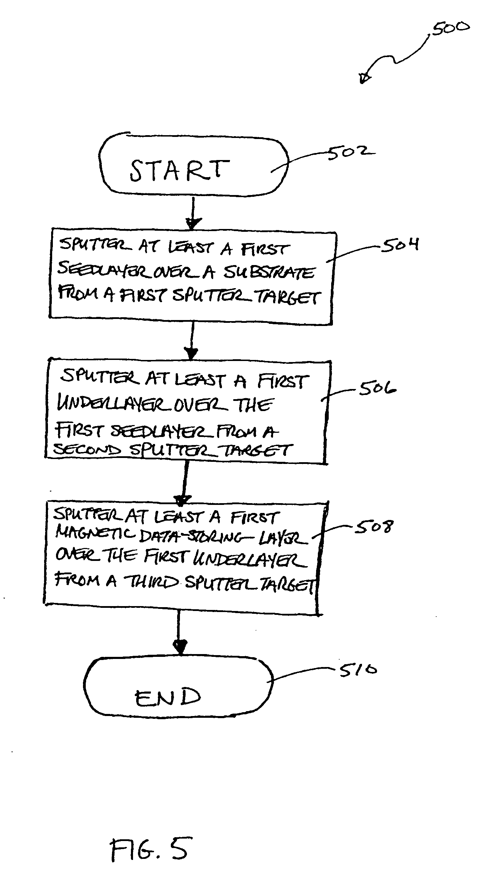

FIG. 5 illustrates a flowchart depicting method 500 for manufacturing a magnetic recording medium, according to a second embodiment of the present invention. Briefly, the method of manufacturing a magnetic recording medium includes the step of sputtering at least a first seedlayer over a substrate from a first sputter target, where the first sputter target is comprised of nickel (Ni) and an alloying element. The method also includes the steps of sputtering at least a first underlayer over the first seedlayer from a second sputter target, and sputtering at least a first magnetic data-storing granular layer over the first underlayer from a third sputter target.

In more detail, the process begins (step 502), at least a first seedlayer is sputtered over a substrate from a first sputter target, where the first sputter target is comprised of nickel (Ni) and an alloying element (step 504). In various embodiments of the present invention, the sputter target may further be comprised of metal oxides. By sputtering the first seedlayer "over" the substrate, it is not necessary that the first seedlayer be in direct physical communication with the seedlayer, since additional layers (e.g., anti-ferromagnetic layers, etc.) may be deposited between the substrate and the first seedlayer. Additionally, in various embodiments of the present invention, layers may be sputtered from the first sputter target or additional targets to form layers between the substrate and the first seedlayer.

According to one aspect associated with this arrangement, the solubility of the alloying element (X) in a face-centered cubic nickel (Ni) phase does not exceed 50 atomic percent at or above room temperature, and the alloying element has a mass susceptibility of less than or equal to $1.5 \times 10^{-7} \frac{m^3}{kg}$. Elements which meet these parameters and which could be used as the alloying element include, but are not limited to boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th). In at least one exemplary embodiment, the alloying element (X) is further alloyed with a metal oxide. The metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof. The at least one metal element of the metal oxide has a reduction potential more negative than nickel (Ni).

According to a second, alternate aspect associated with this arrangement, the alloying element (Y) is soluble in a face-centered cubic nickel (Ni) phase does not exceed 10 atomic percent at or above room temperature, has a mass susceptibility of less than or equal to $1.5 \times 10^{-7} \frac{m^3}{kg}$, and has an atomic radius greater than 1.24 Å. Elements which meet these parameters and which could be used as the alloying element include, but are not limited to aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), or lead (Pb). In at least one exemplary embodiment, the alloying element (Y) is further alloyed with a metal oxide. The metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof. The at least one metal element of the metal oxide has a reduction potential more negative than nickel (Ni).

According to a third, alternate aspect also associated with this arrangement, a first alloying element (X) and second alloying element (Y). The solubility of the alloying element (X) in a face-centered cubic nickel (Ni) phase does not exceed 50 atomic percent at or above room temperature, and the alloying element has a mass susceptibility of less than or equal to $1.5 \times 10^{-7} \frac{m^3}{kg}$. Elements which meet these parameters and which could be used as the alloying element include, but are not limited to boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th). The alloying element (Y) is soluble in a face-centered cubic nickel (Ni) phase does not exceed 10 atomic percent at or above room temperature, has a mass susceptibility of less than or equal to $1.5 \times 10^{-7} \frac{m^3}{kg}$,

and has an atomic radius greater than 1.24 Å. Elements which meet these parameters and which could be used as the alloying element include, but are not limited to aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), or lead (Pb). In at least one exemplary embodiment, the first alloying element (X) and second alloying element (Y) are further alloyed with a metal oxide. The metal oxide has at least one metal element that is silicon (Si), aluminum (A1), titanium (Ti), niobium (Nb), tantalum (Ta), zirconium (Zr), hafnium (Hf), tungsten (W), or any lanthanide, or any combination thereof. The at least one metal element of the metal oxide has a reduction potential more negative than nickel (Ni).

At least a first underlayer is sputtered over the first seedlayer from a second sputter target (step 506). The first underlayer is comprised of ruthenium (Ru) or a ruthenium (Ru)-based alloy, or any other suitable element or alloy. In various embodiments of the present invention, the first underlayer may be co-sputtered with the seedlayer, although seedlayer could also be sputtered separately.

At least a first magnetic data-storing granular layer is sputtered over the first underlayer from a third sputter target (step 508). The first magnetic data-storing granular layer may be co-sputtered with the seedlayer or the first underlayer, although the seedlayer or the first underlayer could also be sputtered separately from the first magnetic data-storing granular layer as well. An additional layer or layers, such as a saturation magnetization adjustment layer may be sputtered over the first magnetic data-storing granular layer which may be CoPt, or CoPt further alloyed with chromium (Cr) or boron (B) or any suitable combination thereof. Other additional layers, such as a carbon (C) overcoat or a lubricant layer, may be sputtered over the first magnetic data-storing granular layer before the process ends (step 510).

The nickel-based alloys (with or without metal oxides) of the various exemplary embodiments described above can be made by powder metallurgical technique or by melt-casting techniques, with or without thermo-mechanical working. However, any other suitable production technique may be utilized.

Based on concepts disclosed by the various exemplary embodiments of the present invention, sputter targets of nickel (Ni) based alloys can be used to produce crystalline nickel (Ni) alloy based seedlayers with refined grain size, refining the grain size of the crystalline underlayer and promoting the subsequently epitaxially deposited granular magnetic layer. The various above-described embodiments of the present invention provide additional approaches to alloy the nickel (Ni) alloy based seedlayer, reducing the lattice mis-fit between the nickel (Ni) alloy based seedlayer and the underlayer, beneficially affecting the crystallinity of the underlayer. Each of these benefits enhances SNR and increases perpendicular anisotropy in the media stacks used for PMR.

The detailed description set forth below in connection with the appended drawings is intended as a description of various embodiments of the invention and is not intended to represent the only embodiments in which the invention may be practiced. The detailed description includes specific details for the purpose of providing a thorough understanding of the invention. However, it will be apparent to those skilled in the art that the invention may be practiced without these specific details. In some instances, well known structures and components are shown in block diagram form in order to avoid obscuring the concepts of the invention.

It is understood that the specific order or hierarchy of steps in the processes disclosed is an example of exemplary approaches. Based upon design preferences, it is understood that the specific order or hierarchy of steps in the processes may be rearranged while remaining within the scope of the present disclosure. The accompanying method claims present elements of the various steps in a sample order, and are not meant to be limited to the specific order or hierarchy presented.

The previous description is provided to enable any person skilled in the art to practice the various embodiments described herein. Various modifications to these embodiments will be readily apparent to those skilled in the art, and the generic principles defined herein may be applied to other embodiments. Thus, the claims are not intended to be limited to the embodiments shown herein, but is to be accorded the full scope consistent with the language claims, wherein reference to an element in the singular is not intended to mean "one and only one" unless specifically so stated, but rather "one or more." All structural and functional equivalents to the elements of the various embodiments described throughout this disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed under the provisions of 35 U.S.C. §112, sixth paragraph, unless the element is expressly recited using the phrase "means for" or, in the case of a method claim, the element is recited using the phrase "step for."

**Claims**

1. A magnetic recording medium, comprising:

   a substrate;

a seedlayer deposited over the substrate, the seedlayer comprised of nickel (Ni) and an alloying element, and wherein the seedlayer is further comprised of metal oxide;
an underlayer deposited over the seedlayer; and
a magnetic data-storing granular layer deposited over the underlayer,

wherein the solubility of the alloying element in a face-centered cubic nickel (Ni) phase does not exceed 50 atomic percent at or above room temperature, and

wherein the alloying element has a mass susceptibility of less than or equal to $1.5 \times 10^{-7} \ \frac{m^3}{kg}$ .

2. The magnetic recording medium according to Claim 1, wherein the alloying element is selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th).

3. The magnetic recording medium according to Claim 1, wherein the underlayer is comprised of ruthenium (Ru) or a ruthenium (Ru)-based alloy.

4. The magnetic recording medium according to Claim 1, wherein the magnetic storing granular layer is CoCrPt.

5. The magnetic recording medium according to Claim 4, wherein the CoCrPt magnetic storing granular layer further comprises oxygen (O).

6. The magnetic recording medium according to Claim 1, further comprising a saturation magnetization adjustment layer deposited over the magnetic storing granular layer.

7. The magnetic recording medium according to Claim 6, wherein the saturation magnetization adjustment layer is CoPt.

8. The magnetic recording medium according to Claim 7, wherein the saturation magnetization adjustment layer is alloyed with chromium (Cr) or boron (B), or a combination thereof.

9. The magnetic recording medium according to Claim 1, wherein the metal oxide has at least one metal element that is silicon (Si), aluminum (A1), titanium (Ti), niobium (Nb), tantalum (Ta), zirconium (Zr), hafnium (Hf), tungsten (W), or any lanthanide, or any combination thereof.

10. The magnetic recording medium according to Claim 9, wherein the at least one metal element of the metal oxide has a reduction potential more negative than nickel (Ni).

11. A magnetic recording medium, comprising:

a substrate;
a seedlayer deposited over the substrate, the seedlayer comprised of nickel (Ni) and an alloying element, and wherein the seedlayer is further comprised of metal oxide;
an underlayer deposited over the seedlayer; and
a magnetic data-storing granular layer deposited over the underlayer,

wherein the alloying element is soluble in nickel (Ni) at or above room temperature,

wherein the alloying element has a mass susceptibility of less than or equal to $1.5 \times 10^{-7} \ \frac{m^3}{kg}$ , and

wherein the alloying element has an atomic radius greater than 1.24 Å.

12. The magnetic recording medium according to Claim 11, wherein the alloying element is selected from the group consisting of aluminum (A1), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb).

13. The magnetic recording medium according to Claim 11, wherein the alloying element is added to nickel (Ni) is less than or equal to 10 atomic percent of its maximum solubility limit at or above room temperature.

14. The magnetic recording medium according to Claim 11, wherein the underlayer is ruthenium (Ru) or a ruthenium (Ru)-based alloy.

15. The magnetic recording medium according to Claim 11, wherein the magnetic storing granular layer is CoCrPt.

16. The magnetic recording medium according to Claim 15, wherein the CoCrPt magnetic storing granular layer further comprises oxygen (O).

17. The magnetic recording medium according to Claim 11, further comprising a saturation magnetization adjustment layer deposited over the magnetic storing granular layer.

18. The magnetic recording medium according to Claim 17, wherein the saturation magnetization adjustment layer is CoPt.

19. The magnetic recording medium according to Claim 18, wherein the saturation magnetization adjustment layer is alloyed with chromium (Cr) or boron (B), or a combination thereof.

20. The magnetic recording medium according to Claim 11, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

21. The magnetic recording medium according to Claim 20, wherein the at least one metal element of the metal oxide has a reduction potential more negative than nickel (Ni).

22. A magnetic recording medium, comprising:

a substrate;
a seedlayer deposited over the substrate, the seedlayer comprised of nickel (Ni) and a first alloying element and a second alloying element;
an underlayer deposited over the seedlayer; and
a magnetic data-storing granular layer deposited over the underlayer.

23. The magnetic recording medium according to Claim 22, wherein solubility of the first alloying element in a face-centered cubic nickel (Ni) phase does not exceed 50 atomic percent at or above room temperature.

24. The magnetic recording medium according to Claim 22, wherein the second alloying element is added to nickel (Ni) is less than or equal to 10 atomic percent of its maximum solubility limit at or above room temperature.

25. The magnetic recording medium according to Claim 22, wherein the first alloying element and the second alloying element have a mass susceptibility of less than or equal to $1.5 \times 10^{-7} \ \frac{m^3}{kg}$ .

26. The magnetic recording medium according to Claim 22, wherein the second alloying element has an atomic radius greater than 1.24 Å.

27. The magnetic recording medium according to Claim 22, wherein the first alloying element is selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th).

28. The magnetic recording medium according to Claim 22, wherein the second alloying element is selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (Tl), and lead (Pb).

29. The magnetic recording medium according to Claim 22, wherein the underlayer is comprised of ruthenium (Ru) or a ruthenium (Ru)-based alloy.

30. The magnetic recording medium according to Claim 22, wherein the magnetic storing granular layer is CoCrPt.

31. The magnetic recording medium according to Claim 30, wherein the CoCrPt magnetic storing granular layer further comprises oxygen (O).

32. The magnetic recording medium according to Claim 22, further comprising a saturation magnetization adjustment layer deposited over the magnetic storing granular layer.

33. The magnetic recording medium according to Claim 32, wherein the saturation magnetization adjustment layer is CoPt.

34. The magnetic recording medium according to Claim 33, wherein the saturation magnetization adjustment layer is alloyed with chromium (Cr) or boron (B), or a combination thereof.

35. The magnetic recording medium of Claim 22, wherein the seedlayer further comprises a metal oxide.

36. The magnetic recording medium according to Claim 35, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

37. The magnetic recording medium according to Claim 36, wherein the at least one metal element of the metal oxide has a reduction potential more negative than nickel (Ni).

38. A sputter target, comprising:

    nickel (Ni);
    an alloying element selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th); and
    metal oxide.

39. The sputter target of Claim 38, wherein the alloying element is present in the sputter target in an amount no more than 50 atomic percent greater than the solid solubility limit of the alloying element in face-centered cubic (FCC) phase nickel (Ni) at or above room temperature.

40. The sputter target of Claim 38, wherein the alloying element is for refining the grain size in an underlayer and a magnetic data-storing granular layer of a magnetic recording medium.

41. The sputter target of Claim 38, wherein the alloying element has a mass susceptibility of less than or equal to

$$1.5 \times 10^{-7} \ \frac{m^3}{kg} \ .$$

42. The sputter target of Claim 38, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

43. The sputter target of Claim 42, wherein the at least one metal element of the metal oxide has a reduction potential more negative than nickel (Ni).

44. A sputter target, comprising:

nickel (Ni); and

an alloying element selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb); and

metal oxide.

45. The sputter target of Claim 44, wherein the alloying element has a mass susceptibility of less than or equal to

$$1.5 \times 10^{-7} \ \frac{m^3}{kg} \ .$$

46. The sputter target of Claim 44, wherein the alloying element is present in the sputter target in an amount less than or equal to 10 atomic percent of the solid solubility limit of the alloying element in face-centered cubic (FCC) phase nickel (Ni) at or above room temperature.

47. The sputter target of Claim 44, wherein the alloying element is for reducing lattice misfit with an underlayer, reducing interface stresses, and enhancing the crystallinity of the underlayer for the magnetic data-storing granular layer of a magnetic recording medium.

48. The sputter target of Claim 47, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

49. The sputter target of Claim 48, wherein the at least one metal element of the metal oxide has a reduction potential more negative than nickel (Ni).

50. A sputter target, comprising:

nickel (Ni);

a first alloying element selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th); and

a second alloying element selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (Tl), and lead (Pb).

51. The sputter target of Claim 50, wherein the first alloying element is present in the sputter target in an amount no more than 50 atomic percent greater than the solid solubility limit of the alloying element in face-centered cubic (FCC) phase nickel (Ni) at or above room temperature.

52. The sputter target of Claim 50, wherein the first alloying element is for refining the grain size in an underlayer and a magnetic data-storing granular layer of a magnetic recording medium.

53. The sputter target of Claim 50, wherein the first alloying element and second alloying element have a mass susceptibility of less than or equal to $1.5 \times 10^{-7} \ \frac{m^3}{kg} \ .$

54. The sputter target of Claim 50, further comprising metal oxide.

55. The sputter target of Claim 54, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

56. The sputter target of Claim 55, wherein the at least one metal element of the metal oxide has a reduction potential more negative than nickel (Ni).

57. The sputter target of Claim 50, wherein the second alloying element has an atomic radius greater than 1.24 Å.

58. The sputter target of Claim 50, wherein the second alloying element is present in the sputter target in an amount less than or equal to 10 atomic percent of the solid solubility limit of the alloying element in face-centered cubic (FCC) phase nickel (Ni) at or above room temperature.

59. The sputter target of Claim 50, wherein the second alloying element is for reducing lattice misfit with an underlayer, reducing interface stresses, and enhancing the crystallinity of the underlayer for the magnetic data-storing granular layer of a magnetic recording medium.

60. A method of manufacturing a magnetic recording medium, comprising the steps of:

   sputtering at least a first seedlayer over a substrate from a first sputter target, wherein the first sputter target is comprised of nickel (Ni) and an alloying element, wherein solubility of the alloying element in a face-centered cubic nickel (Ni) phase does not exceed 50 atomic percent at or above room temperature, wherein the alloying element has a mass susceptibility of less than or equal to $1.5 \times 10^{-7} \, \dfrac{m^3}{kg}$, and wherein the first sputter target is further comprised of metal oxide;
   sputtering at least a first underlayer over the first seedlayer from a second sputter target; and
   sputtering at least a first magnetic data-storing granular layer over the first underlayer from a third sputter target.

61. The method according to Claim 60, wherein the alloying element is selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th).

62. The method according to Claim 60, wherein the metal oxide wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

63. The method according to Claim 62, wherein the at least one metal element of the metal oxide can have a reduction potential more negative than nickel (Ni).

64. The method according to Claim 60, wherein the first seedlayer, the first underlayer, or the first magnetic data-storing granular layer, or any combination thereof are sputtered using a co-sputtering assembly.

65. A method of manufacturing a magnetic recording medium, comprising the steps of:

   sputtering at least a first seedlayer over a substrate from a first sputter target, wherein the first sputter target is comprised of nickel (Ni) and an alloying element, wherein solubility of the alloying element in a face-centered cubic nickel (Ni) phase is less than or equal to 10 atomic percent at or above room temperature, and wherein the alloying element has a mass susceptibility of less than or equal to $1.5 \times 10^{-7} \, \dfrac{m^3}{kg}$, and wherein the first sputter target is further comprised of metal oxide;
   sputtering at least a first underlayer over the first seedlayer from a second sputter target; and
   sputtering at least a first magnetic data-storing granular layer over the first underlayer from a third sputter target.

66. The method according to Claim 65, wherein the alloying element is selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (Tl), and lead (Pb).

67. The method according to Claim 65, wherein the alloying element has an atomic radius greater than 1.24 Å.

68. The method according to Claim 65, wherein the metal oxide wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

69. The method according to Claim 68, wherein the at least one metal element of the metal oxide can have a reduction potential more negative than nickel (Ni).

70. A method of manufacturing a magnetic recording medium, comprising the steps of:

sputtering at least a first seedlayer over a substrate from a first sputter target, wherein the first sputter target is comprised of nickel (Ni) and a first alloying element and a second alloying element, wherein solubility of the first alloying element in a face-centered cubic nickel (Ni) phase does not exceed 50 atomic percent at room temperature, wherein the solubility of the second alloying element in a face-centered cubic nickel (Ni) phase is less than or equal to atomic percent at or above room temperature, and wherein the first and second alloying elements have a mass susceptibility of less than or equal to $1.5 \times 10^{-7} \frac{m^3}{kg}$;

sputtering at least a first underlayer over the first seedlayer from a second sputter target; and
sputtering at least a first magnetic data-storing granular layer over the first underlayer from a third sputter target.

71. The method according to Claim 70, wherein the first alloying element is selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th).

72. The method according to Claim 70, wherein the alloying element is selected from the group consisting of aluminum (A1), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb).

73. The method according to Claim 70, wherein the second alloying element has an atomic radius greater than 1.24 Å.

74. The method according to Claim 70, wherein the first sputter target is further comprised of a metal oxide.

75. The method according to Claim 74, wherein the metal oxide wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

76. The method according to Claim 75, wherein the at least one metal element of the metal oxide can have a reduction potential more negative than nickel (Ni).


**Amended claims in accordance with Rule 137(2) EPC.**

1. A magnetic recording medium, comprising:

a substrate;
a seedlayer deposited over the substrate, the seedlayer comprised of nickel (Ni) and an alloying element, and wherein the seedlayer is further comprised of metal oxide;
an underlayer deposited over the seedlayer; and
a magnetic data-storing granular layer deposited over the underlayer,

wherein the of the alloying element in a face-centered cubic nickel (Ni) phase does not exceed 50 atomic percent at or above room temperature, and

wherein the alloying element has a mass susceptibility of less than or equal to $1.5 \times 10^{-7} \frac{m^3}{kg}$.

2. The magnetic recording medium according to Claim 1, wherein the alloying element is selected from the group consisting of boron (B), carbon manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th),

**3.** The magnetic recording medium according to Claim 1, wherein the underlayer is comprised of ruthenium (Ru) or a ruthenium (Ru)-based alloy.

**4.** The magnetic recording medium according to Claim 1, wherein the magnetic storing granular layer is CoCrPt.

**5.** The magnetic recording medium according to Claim 4, wherein the CoCrPt magnetic storing granular layer further comprises oxygen (O).

**6.** The magnetic recording medium according to Claim 1, further comprising a saturation magnetization adjustment layer deposited over the magnetic storing granular layer,

**7.** The magnetic recording medium according to Claim 6, wherein the saturation magnetization adjustment layer is CoPt.

**8.** The magnetic recording medium according to Claim 7, wherein the saturation magnetization adjustment layer is alloyed with chromium (Cr) or boron (B), or a combination thereof.

**9.** The magnetic recording medium according to Claim 1, wherein the metal oxide has at least one metal element that is silicon (Si), aluminum (A1), titanium (Ti), niobium (Nb), tantalum (Ta), zirconium (Zr), hafnium (Hf), tungsten (W), or any lanthanide, or any combination thereof.

**10.** The magnetic recording medium according to Claim 9, wherein the at least one metal element of the metal oxide has a reduction potential more negative than nickel (Ni).

**11.** A magnetic recording medium, comprising:

a substrate;
a seedlayer deposited over the substrate, the seedlayer comprised of nickel (Ni) and an alloying element, and wherein the seedlayer is further comprised of metal oxide;
an underlayer deposited over the seedlayer; and
a magnetic data-storing granular layer deposited over the underlayer,

wherein the alloying element is soluble in nickel (Ni) at or above room temperature,

wherein the alloying element has a mass susceptibility of less than or equal to $1.5 \times 10^{-7} \, \frac{m^3}{kg}$, and

wherein the alloying element has an atomic radius greater than 1.24 Å.

**12.** The magnetic recording medium according to Claim 11, wherein the alloying element is selected from the group consisting of aluminum (Al), silicon (Si), titanium (Ti), vanadium (V), chromium (Cr), zinc (Zn), germanium (Ge), niobium(Nb), molybdenum (Mo), 7 ruthenium (Ru), tantalum (Ta), tungsten (W), rhenium (Re), osmium (Os), thallium (T1), and lead (Pb).

**13.** The magnetic recording medium according to Claim 11, wherein the alloying element is added to nickel (Ni) in an amount less than or equal to 10 atomic percent of its maximum solubility limit at or above room temperature.

**14.** The magnetic recording medium according to Claim 11, wherein the underlayer is ruthenium (Ru)or a ruthenium (Ru)-based alloy.

**15.** The magnetic recording medium according to Claim 11, wherein the magnetic storing granular layer is CoCrPt.

**16.** The magnetic recording medium according to Claim 15, wherein the CoCrPt magnetic storing granular layer further comprises oxygen (O).

**17.** The magnetic recording medium according to Claim 11, further comprising a saturation magnetization adjustment layer deposited over the magnetic storing granular layer.

**18.** The magnetic recording medium according to Claim 17, wherein the saturation magnetization adjustment layer is CoPt.

**19.** The magnetic recording medium according to Claim 18, wherein the saturation magnetization adjustment layer is alloyed with chromium (Cr) or boron (B), or a combination thereof.

**20.** The magnetic recording medium according to Claim 11, wherein the metal oxide has at least one metal element that is silicon (Si), aluminum (Al), titanium (Ti), niobium (Nb), tantalum (Ta), zirconium (Zr), hafnium , (Hf), tungsten (W), or any lanthanide, or any combination thereof.

**21.** The magnetic recording medium according to Claim 20, wherein the at least one metal element of the metal oxide has a reduction potential more negative than nickel (Ni).

**22.** A magnetic recording medium, comprising:

a substrate;
a seedlayer deposited over the substrate, the seedlayer comprised of nickel (Ni) and a first alloying element and a second alloying element;
an underlayer deposited over the seedlayer; and
a magnetic data-storing granular layer deposited over the underlayer.

**23.** The magnetic recording medium according to Claim 22, wherein solubility of the first alloying element in a face-centered cubic nickel (Ni) phase does not exceed 50 atomic percent at or above room temperature.

**24.** The magnetic recording medium according to Claim 22, wherein the second alloying element is added to nickel (Ni) in an amount less than or equal to 10 atomic percent of its maximum solubility limit at or above room temperature.

**25.** The magnetic recording medium according to Claim 22, wherein the first alloying element and the second alloying element have a mass susceptibility of less than or equal to $1.5 \times 10^{7} \frac{m^3}{kg}$.

**26.** The magnetic recording medium according to Claim 22, wherein the second alloying has atomic radius greater than 1.24 Å.

**27.** The recording medium according to Claim 22, wherein the first alloying element is selected the group consisting of boron (B), carbon (C), manganese (Mn), copper (Cu), ytrium (Y), zirconium (Zr), rhodium (Bh), silver (Ag), cadmium (Cd), ytterbium (Yb), hafnium (Hf), iridium (Ir), platinum (Pt), gold (Au), bismuth (Bi), and thorium (Th).

**28.** The recording medium according to Claim 22, wherein the second alloying element is selected from the group consisting of aluminum (Al), silicon (Si), titanium (Ti), vanadium (V), chromium (Ci), zinc (Zn), germanium (Ge), niobium (Nb), molybdenum (Mo), ruthenium (Ru), tantalum (Ta), tungsten (W), rhenium (Re), osmium (Os), thallium (Tl), and lead (Pb).

**29.** The recording medium according to Claim 22, wherein the underlayer is comprised of ruthenium (Ru) or a ruthenium (Ru)-based alloy.

**30.** The recording medium according to Claim 22, wherein the magnetic storing granular layer is CoCrPt.

**31.** The magnetic recording medium according to Claim 30, wherein the CoCrPt magnetic storing granular layer further comprises oxygen (O).

**32.** The magnetic recording medium according to Claim 22, further comprising a saturation magnetization adjustment layer deposited over the magnetic storing granular layer.

**33.** The magnetic recording medium according to Claim 32, wherein the saturation magnetization adjustment layer is CoPt.

**34.** The magnetic recording medium according to Claim 33, wherein the saturation magnetization layer is alloyed with chromium (Cr) or boron (B), or a combination thereof.

**35.** The magnetic recording medium of Claim 22, wherein the seedlayer further comprises a metal oxide.

**36.** The magnetic recording medium according to Claim 35, wherein the metal oxide has at least one metal, element that is silicon (Si), aluminum (Al), titanium (Ti), niobium (Nb), tantalum (Ta), zirconium (Zr), hafnium (Hf), tungsten (W), or any lanthanide, or any combination thereof.

**37.** The magnetic recording medium according to Claim 36, wherein the at least one metal element of the metal oxide has a reduction potential more negative than nickel (Ni).

**38.** A sputter target, comprising:

nickel (Ni);
an alloying element selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium (Th); and
metal oxide.

**39.** The sputter target of Claim 38, wherein the alloying element is present in the sputter target in an amount no more than 50 atomic percent greater than the solid solubility limit of the alloying element in face-centered cubic (FCC) phase nickel (Ni) at or above room temperature.

**40.** The spatter target of Claim 38, wherein the alloying element is for refining the grain size in an underlayer and a magnetic data-storing granular layer of a magnetic recording medium.

**41.** The sputter target of Claim 38, wherein the alloying element has a mass susceptibility of less than or equal to

$$1.5 \times 10^{-7} \; \frac{m^3}{kg} \; .$$

**42.** The sputter target of Claim 38, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

**43.** The sputter target of Claim 42, wherein the at least one metal element of the metal oxide has a reduction potential more negative than nickel (Ni).

**44.** A sputter target, comprising:

nickel (Ni); and
an alloying selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb); and
metal oxide.

**45.** The sputter target of Claim 44, wherein the alloying element has a mass susceptibility of less than or equal to

$$1.5 \times 10^{-7} \; \frac{m^3}{kg} \; .$$

**46.** The sputter target of Claim 44, wherein the alloying element is present in the sputter target in an amount less than or equal to 10 atomic percent of the solid solubility limit of the allying element in face-centered cubic (FCC) phase nickel (Ni) at or above room temperature.

**47.** The sputter target of Claim 44, wherein the alloying element is for reducing lattice misfit with an reducing interface stresses, and enhancing the crystallinity of the underlayer for the magnetic data-storing granular layer of a magnetic recording medium.

**48.** The sputter target of Claim 47, wherein the metal oxide has at least one metal element that is silicon (Si), aluminum (Al), titanium (Ti), niobium (Nb), tantalum (Ta), zirconium m (Zr), hafnium (Hf), tungsten (W), or any lanthanide, or any combination thereof.

**49.** The sputter target of Claim 48, wherein the at least one metal element of the metal oxide has a reduction potential more negative than nickel (Ni).

**50.** A sputter target, comprising;

nickel (Ni);
a first alloying element selected from the group consisting of boron (B), carbon (C), manganese copper (Cu), yttrium (Y), zirconium (Zr), rhodium (Rh), silver (Ag), cadmium (Cd), ytterbium (Yb), hafnium (Hf), indium (Ir), platinum (Pt), gold (Au), bismuth (Bi), and thorium (Th), and
a second element selected from the group consisting of aluminum (A1), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1) and lead (Pb).

**51.** The spatter target of Claim 50, wherein the first alloying element is present in the sputter target in an amount no more than 50 atomic percent greater than the solid solubility limit of the alloying element in face-centered cubic (FCC) phase nickel (Ni) at or above room temperature.

**52.** The sputter target of Claim 50, wherein the first alloying element is for refining the grain size in an underlayer and a magnetic data-storing granular layer of a magnetic recording medium.

**53.** The sputter target of Claim 50, wherein the first alloying element and second alloying element have a mass susceptibility of less than or equal to $1.5 \times 10^{-7} \ \frac{m^3}{kg}$ .

**54.** The sputter target of Claim 50, further comprising metal oxide.

**55.** The spatter target of Claim 54, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

**56.** The spatter target of Claim 55, wherein the at least one metal element of the metal oxide has a reduction potential more negative than nickel (Ni).

**57.** The spatter target of Claim 50, wherein the second alloying element has an atomic radius greater than 1.24 Å.

**58.** The spatter target of Claim 50, wherein the second alloying element is present in the sputter target in an less than or equal to 10 atomic percent of the solid solubility limit of the alloying element in face-centered cubic (FCC) phase nickel (Ni) at or above room temperature.

**59.** The sputter target of Claim 50, wherein the second alloying element is for reduce lattice with an underlayer, reducing interface stresses, and enhancing the crystallinity of the for the magnetic data-storing granular layer of a magnetic recording medium.

**60.** A method of manufacturing a magnetic recording medium, comprising the steps of:

sputtering at least a seedlayer over a substrate from a first sputter target, wherein the first sputter target is comprised of nickel (Ni) and an alloying element, wherein solubility of the alloying element in a face-centered cubic nickel (Ni) phase does not exceed 50 atomic percent at or above room temperature, wherein the alloying element has a mass susceptibility of less than or equal to $1.5 \times 10^{-7} \frac{m^3}{kg}$, and wherein the first sputter target
is further comprised of metal oxide;
sputtering at least a first underlayer over the first seedlayer from a second sputter target; and
sputtering at least a first magnetic data-storing granular layer over the first underlayer from a third sputter target.

61. The method according to Claim 60, wherein the alloying element is selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Ir), platinum (Pt), gold (Au), bismuth (Bi), and thorium(Th).

62. The method according to Claim 60, wherein the metal oxide has at least one metal element that is silicon (Si), aluminum (Al), titanium (Ti), niobium (Nb), tantalum (Ta), zirconium (Zr), hafnium (Hf), tungsten (W), or any lanthanide, or any combination thereof.

63. The method according to Claim 62, wherein the at least one metal element of the metal oxide can have a reduction potential more negative than nickel (Ni).

64. The according to Claim 60, wherein the first seedlayer, the first underlayer, or the first magnetic data-storing granular layer, or any combination thereof are sputtered using a co-sputtering assembly.

65. A of manufacturing a magnetic recording medium, comprising the steps of:

sputtering at least a first seedlayer over a substrate from a first sputter target, wherein the first sputter target is comprised of nickel (Ni) and an alloying element, wherein solubility of the alloying element a face-centered cubic nickel (Ni) phase is less than or equal to 10 atomic percent or above room temperature, and wherein the alloying element has a mass susceptibility of less or equal to $1.5 \times 10^{-7} \frac{m^3}{kg}$, and wherein the first sputter target is further comprised of metal oxide;
sputtering at least a underlayer over the first seedlayer from a second sputter target; and
sputtering at least a first magnetic data-storing granular layer over the first underlayer from a third sputter target.

66. The method according to Claim 65, wherein the alloying element is selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (Tl), and lead (Pb).

67. The method according to Claim 65, wherein the alloying element has an atomic radius greater than 1.24 Å.

68. The according to Claim 65, wherein the metal oxide wherein the metal oxide has at least one metal element that is silicon (Si), aluminum (Al), titanium (Ti), niobium (Nb), tantalum (Ta) zircomum (Zr), hafnium (Hf), tungsten (W), or any lanthanide, or any combination thereof.

69. The according to Claim 68, wherein the at least one metal element of the metal oxide can have a reduction potential more negative than nickel (Ni).

70. A method of manufacturing a magnetic recording medium, comprising the steps of:

sputtering at least a first seedlayer over a substrate from a first sputter target, wherein the first sputter target is comprised of nickel (Ni) and a first alloying element and a second alloying element, wherein solubility of the first alloying element in a face-centered cubic nickel (Ni) phase does not exceed 50 atomic percent at room temperature, wherein the solubility of the second alloying element in a face-centered cubic nickel (Ni) phase is less than or equal to 10 atomic percent at or above room temperature, and wherein the first and second alloying elements have a mass susceptibility of less than or equal to $1.5 \times 10^{-7} \frac{m^3}{kg}$;

sputtering at least a first underlayer over the first seedlayer from a second sputter target; and
sputtering at least a first magnetic data-storing granular layer over the first underlayer from a third sputter target.

**71.** The method according to Claim 70, wherein the first alloying element is selected from the group consisting of boron (B), carbon (C), manganese (Mn), copper (Cu), yttrium (Y), zirconium (Zr), rhodium (Rh), silver (Ag), cadmium (Cd), ytterbium (Yb), hafnium (Hf), iridium (Tr), platinum (Pt), gold (Au), bismuth (Bi), and thorium (Th).

**72.** The according to Claim 70, wherein the second alloying element is selected from the group consisting of aluminum (Al), silicon (Si), titanium (Ti), vanadium (V), chromium (Cr), zinc (Zn), germanium (Ge), niobium (Nb), molybdenum (Mo), ruthenium (Ru), tantalum (Ta), tungsten (W), rhenium (Re), osmium (Os), thallium (T1), and lead (Pb).

**73.** The method according to Claim 70, wherein the second alloying element has an atomic radius greater than 1.24 Å.

**74.** The method according to Claim 70, wherein the first sputter target is further comprised of a metal oxide.

**75.** The method according to Claim 74, wherein the metal oxide has at least element that is silicon (Si), aluminum (Al), titanium (Ti), niobium (Nb), tantalum (Ta), zirconium (Zr), hafnium (Hf), tungsten (W), or any lanthanide, or any combination thereof.

**76.** The method according to Claim 75, wherein the at least one metal element of the metal oxide can have a reduction potential more negative than nickel (Ni).

FIG. 1
PRIOR ART

102
104
106
108
110

100

EP 1 930 884 A1

FIG. 2

Ni + Alloying Element(s)

202
204
206
208
210

200

300

FIG. 3

FCC (111) Ni plane        Ru (0002) plane

FIG.4

500

START — 502

SPUTTER AT LEAST A FIRST SEEDLAYER OVER A SUBSTRATE FROM A FIRST SPUTTER TARGET — 504

SPUTTER AT LEAST A FIRST UNDERLAYER OVER THE FIRST SEEDLAYER FROM A SECOND SPUTTER TARGET — 506

SPUTTER AT LEAST A FIRST MAGNETIC DATA-STORING LAYER OVER THE FIRST UNDERLAYER FROM A THIRD SPUTTER TARGET — 508

END — 510

FIG. 5

**European Patent Office**

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2000 155925 A (NIPPON SHEET GLASS) 6 June 2000 (2000-06-06)  * claims 1,2; figure 1 * | 1,2,4, 9-13,15, 17, 20-28, 30,32, 35-76 | INV. G11B5/84 G11B5/73 C23C14/34 |
| X | US 2003/003327 A1 (MATSUDA ET AL.) 2 January 2003 (2003-01-02)  * paragraphs [0031], [0060]; figure 1 * | 1,2, 6-13, 17-28, 32-76 | |
| X | US 2003/118871 A1 (HOSOE ET AL.) 26 June 2003 (2003-06-26)  * paragraphs [0019], [0022], [0023], [0038]; figure 1 * | 1,2, 6-13, 17-28, 32-76 | |
| Y | US 2005/153169 A1 (WATANABE ET AL.) 14 July 2005 (2005-07-14) * paragraphs [0074] - [0077]; figure 1 * | 1-76 | **TECHNICAL FIELDS SEARCHED (IPC)** G11B C23C |
| Y | EP 1 293 969 A (FUJI) 19 March 2003 (2003-03-19)  * page 11, line 21 - line 47 * * page 13, line 28 - line 32; figure 5B * | 1-5, 9-16, 20-31, 35-76 | |
| Y | US 2004/000374 A1 (WATANABE ET AL.) 1 January 2004 (2004-01-01)  * paragraphs [0010], [0028], [0029]; figure 1 * | 1-5, 9-16, 20-31, 35-76 | |

-/--

The present search report has been drawn up for all claims

| Place of search | Date of completion of the search | Examiner |
|---|---|---|
| The Hague | 11 September 2007 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................
& : member of the same patent family, corresponding document

EPO FORM 1503 03.82 (P04C01)

**European Patent
Office**

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 5 405 646 A (NANIS) 11 April 1995 (1995-04-11)<br><br>* column 5, line 62 - line 66 *<br>* column 7, line 1 - line 11; figure 4 *<br>----- | 1,2, 9-13, 20-28, 36-76 | |
| Y | JP 2001 295037 A (HITACHI) 26 October 2001 (2001-10-26) * paragraphs [0001], [0008]; figure 3 *<br>----- | 1-76 | |
| X | WO 2004/070710 A (FUJITSU) 19 August 2004 (2004-08-19)<br><br>* claims 1-22 *<br>----- | 11-15, 17-21, 44-49, 65-69 | |
| X | US 2005/084669 A1 (GIRT ET AL.) 21 April 2005 (2005-04-21)<br><br>* paragraphs [0029], [0030], [0041], [0042], [0048], [0049] *<br>----- | 11-15, 17-21, 44-49, 65-69 | TECHNICAL FIELDS SEARCHED (IPC) |
| X | US 6 740 397 B1 (LEE) 25 May 2004 (2004-05-25)<br><br>* column 10, line 8 - line 31; claims 1-10,22,25,28 *<br>----- | 11-15, 17-21, 44-49, 65-69 | |
| X | US 2002/064690 A1 (CHEN ET AL.) 30 May 2002 (2002-05-30)<br><br>* paragraphs [0045] - [0047], [0058], [0059] *<br>----- | 11-13, 15, 17-21, 44-49, 65-69 | |

-/--

The present search report has been drawn up for all claims

| Place of search | Date of completion of the search | Examiner |
|---|---|---|
| The Hague | 11 September 2007 | Magrizo, Simeon |

EPO FORM 1503 03.82 (P04C01)

**European Patent Office**

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 855 439 B1 (ROU ET AL.) 15 February 2005 (2005-02-15)<br><br>* column 6, line 55 - column 7, line 5 *<br>* column 7, line 49 - column 8, line 22 *<br>* column 9, line 11 - line 25 *<br>----- | 11-13, 15, 17-21, 44-49, 65-69 | |
| X | US 6 641 936 B1 (CHEN ET AL.) 4 November 2003 (2003-11-04)<br><br>* column 7, line 30 - column 8, line 4 *<br>* column 9, line 4 - line 21; claims 6-9 *<br>----- | 11-13, 15, 17-21, 44-49, 65-69 | |
| X | US 6 620 531 B1 (CHENG) 16 September 2003 (2003-09-16)<br><br>* column 5, line 54 - column 6, line 17; claim 1 *<br>----- | 11-13, 15, 17-21, 44-49, 65-69 | TECHNICAL FIELDS SEARCHED (IPC) |
| X | US 6 572 958 B1 (CHOUR ET AL.) 3 June 2003 (2003-06-03)<br><br>* column 6, line 49 - line 64; claims 7,14,18; figure 2 *<br>----- | 11-13, 15, 17-21, 44-49, 65-69 | |

-/--

The present search report has been drawn up for all claims

| Place of search | Date of completion of the search | Examiner |
|---|---|---|
| The Hague | 11 September 2007 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 475 611 B1 (CHEN) 5 November 2002 (2002-11-05)  * column 3, line 35 - column 4, line 7 * ----- | 11-13, 15, 17-21, 44-49, 65-69 | |
| X | US 6 403 241 B1 (CHEN ET AL.) 11 June 2002 (2002-06-11)  * column 3, line 44 - line 67 * * column 5, line 21 - line 51 * ----- | 11-13, 15, 17-21, 44-49, 65-69 | |
| X | US 6 348 276 B1 (CHEN ET AL.) 19 February 2002 (2002-02-19)  * claims 1-10 * ----- | 11-13, 15, 17-21, 44-49, 65-69 | |
| X | US 6 346 339 B1 (HARKNESS ET AL.) 12 February 2002 (2002-02-12)  * column 4, line 19 - line 37 * ----- | 11-13, 15, 17-21, 44-49, 65-69 | TECHNICAL FIELDS SEARCHED (IPC) |
| X | US 6 117 570 A (CHEN ET AL.) 12 September 2000 (2000-09-12)  * column 5, line 12 - line 36; claims 1-9 * -----  -/-- | 11-13, 15, 17-21, 44-49, 65-69 | |

The present search report has been drawn up for all claims

| Place of search | Date of completion of the search | Examiner |
|---|---|---|
| The Hague | 11 September 2007 | Magrizo, Simeon |

**European Patent Office**

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/095421 A1 (WU ET AL.) 5 May 2005 (2005-05-05)<br><br>* paragraphs [0022], [0023], [0028] - [0030] * | 11-13, 15-18, 20,21, 44-49, 65-69 | |
| X | US 2004/214049 A1 (YAMAMOTO ET AL.) 28 October 2004 (2004-10-28)<br><br>* paragraphs [0028] - [0031], [0041] - [0043] * | 22-30, 32-37, 50-59, 70-76 | |
| X | US 2003/219631 A1 (TAKAHASHI ET AL.) 27 November 2003 (2003-11-27)<br><br>* paragraphs [0029], [0030], [0053], [0066]; figure 1 * | 22-30, 32-37, 50-59, 70-76 | |
| X | US 2004/038083 A1 (HIRAYAMA ET AL.) 26 February 2004 (2004-02-26)<br><br>* paragraphs [0049], [0068]; figure 1 * | 22-28, 30-37, 50-59, 70-76 | TECHNICAL FIELDS SEARCHED (IPC) |
| X | EP 1 720 156 A (HITACHI) 8 November 2006 (2006-11-08)<br><br>* paragraphs [0012] - [0017]; figure 3 * | 22-33, 50-53, 57-59, 70-73 | |

-/--

The present search report has been drawn up for all claims

| Place of search | Date of completion of the search | Examiner |
|---|---|---|
| The Hague | 11 September 2007 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/006310 A (TOSHIBA) 20 January 2005 (2005-01-20)<br><br>* page 23, line 13 - line 17; claims 1-14; figures 1-6 * | 22-33, 50-53, 57-59, 70-73 | |
| X | US 2006/090998 A1 (HONDA ET AL.) 4 May 2006 (2006-05-04)<br><br>* paragraph [0033]; claims 1-8; figure 1 * | 22-33, 50-53, 57-59, 70-73 | |
| X | US 2006/057430 A1 (KUBOKI) 16 March 2006 (2006-03-16)<br><br>* paragraph [0046]; claims 1-12; figure 1 * | 22-33, 50-53, 57-59, 70-73 | |
| X | US 2005/142388 A1 (HIRAYAMA ET AL.) 30 June 2005 (2005-06-30)<br><br>* paragraphs [0054], [0056]; claims 1-16; figure 1 * | 22-33, 50-53, 57-59, 70-73 | TECHNICAL FIELDS SEARCHED (IPC) |
| X | US 2004/110034 A1 (KAWADA) 10 June 2004 (2004-06-10)<br><br>* paragraphs [0067], [0079], [0089]; claims 1,6,9-12 * | 22-33, 50-53, 57-59, 70-73 | |

-/--

The present search report has been drawn up for all claims

| Place of search | Date of completion of the search | Examiner |
|---|---|---|
| The Hague | 11 September 2007 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/093719 A (TOSHIBA) 6 October 2005 (2005-10-06)<br><br>* paragraphs [0010], [0019] - [0022], [0026], [0032]; figures 1-3 *<br>----- | 22-28, 30-33, 50-53, 57-59, 70-73 | |
| X | US 2004/191571 A1 (HIRAYAMA ET AL.) 30 September 2004 (2004-09-30)<br><br>* paragraphs [0042] - [0049]; figure 1A *<br>----- | 22-28, 30-33, 50-53, 57-59, 70-73 | |
| X | US 2002/110706 A1 (MIYAMOTO) 15 August 2002 (2002-08-15)<br><br>* paragraphs [0149], [0150], [0218] - [0221]; figure 1 *<br>----- | 22-28, 30-33, 50-53, 57-59, 70-73 | |
| X | US 2002/037440 A1 (ONO ET AL.) 28 March 2002 (2002-03-28)<br><br>* paragraphs [0037], [0038]; figure 1 *<br>----- | 22-28, 30-33, 50-53, 57-59, 70-73 | TECHNICAL FIELDS SEARCHED (IPC) |
| X | US 6 395 634 B1 (MIYAMOTO) 28 May 2002 (2002-05-28)<br><br>* column 11, line 34 - line 64 *<br>* column 15, line 52 - column 16, line 11; figure 1 *<br>-----<br>-/-- | 22-28, 30-33, 50-53, 57-59, 70-73 | |

The present search report has been drawn up for all claims

| Place of search | Date of completion of the search | Examiner |
|---|---|---|
| The Hague | 11 September 2007 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 07 25 0678

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 383 404 B1 (SAKAI ET AL.) 7 May 2002 (2002-05-07)<br><br>* column 13, line 33 - line 61 * <br>* column 17, line 45 - column 18, line 9 *<br>----- | 22-28, 30-33, 50-53, 57-59, 70-73 | |
| X | US 2005/069730 A1 (DOERNER ET AL.) 31 March 2005 (2005-03-31)<br><br>* paragraphs [0012], [0013]; claim 7; figure 2 *<br>----- | 22-28, 30, 32-34, 50-53, 57-59, 70-73 | |
| X | US 2002/146594 A1 (TAKAHASHI ET AL.) 10 October 2002 (2002-10-10)<br><br>* paragraphs [0062], [0063], [0073], [0083] - [0086], [0098] - [0100] *<br>----- | 22-28, 30, 32-34, 50-53, 57-59, 70-73 | TECHNICAL FIELDS SEARCHED (IPC) |
| X | US 6 511 761 B1 (TANAHASHI ET AL.) 28 January 2003 (2003-01-28)<br><br>* column 4, line 46 - line 67; claims 1-4 *<br>----- | 22-28, 30, 32-34, 50-53, 57-59, 70-73 | |

The present search report has been drawn up for all claims

| Place of search | Date of completion of the search | Examiner |
|---|---|---|
| The Hague | 11 September 2007 | Magrizo, Simeon |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

Application Number

EP 07 25 0678

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**LACK OF UNITY OF INVENTION
SHEET B**

The Search Division considers that the present European patent application does not comply with the
requirements of unity of invention and relates to several inventions or groups of inventions, namely:

1. claims: 1-10, 38-43, 60-64

    A magnetic recording medium, a method for its manufacture
    and a sputter target comprising a seed layer with nickel,
    metal oxide and an alloying element selected from B, C, Mn,
    Cu, Y, Zr, Rh, Ag, Cd, Yb, Hf, Ir, Pt, Au, Bi, Th
    ---

2. claims: 11-21, 44-49, 65-69

    A magnetic recording medium, a method for its manufacture
    and a sputter target comprising a seed layer with nickel,
    metal oxide and an alloying element selected from Al, Si,
    Ti, V, Cr, Zn, Ge, Nb, Mo, Ru, Ta, W, Re, Os, Tl, Pb
    ---

3. claims: 22-37, 50-59, 70-76

    A magnetic recording medium, a method for its manufacture
    and a sputter target comprising a seed layer with nickel, a
    first alloying element selected from B, C, Mn, Cu, Y, Zr,
    Rh, Ag, Cd, Yb, Hf, Ir, Pt, Au, Bi, Th and a second alloying
    element selected from Al, Si, Ti, V, Cr, Zn, Ge, Nb, Mo, Ru,
    Ta, W, Re, Os, Tl, Pb
    ---

## ANNEX TO THE EUROPEAN SEARCH REPORT
## ON EUROPEAN PATENT APPLICATION NO.

EP 07 25 0678

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2007

| Patent document cited in search report | | Publication date | Patent family member(s) | | Publication date |
|---|---|---|---|---|---|
| JP 2000155925 | A | 06-06-2000 | NONE | | |
| US 2003003327 | A1 | 02-01-2003 | NONE | | |
| US 2003118871 | A1 | 26-06-2003 | NONE | | |
| US 2005153169 | A1 | 14-07-2005 | JP 2005196898 A<br>SG 113516 A1 | | 21-07-2005<br>29-08-2005 |
| EP 1293969 | A | 19-03-2003 | DE 60212281 T2<br>US 2003134151 A1 | | 16-05-2007<br>17-07-2003 |
| US 2004000374 | A1 | 01-01-2004 | SG 118182 A1<br>US 2007009654 A1 | | 27-01-2006<br>11-01-2007 |
| US 5405646 | A | 11-04-1995 | NONE | | |
| JP 2001295037 | A | 26-10-2001 | NONE | | |
| WO 2004070710 | A | 19-08-2004 | AU 2003206135 A1 | | 30-08-2004 |
| US 2005084669 | A1 | 21-04-2005 | NONE | | |
| US 6740397 | B1 | 25-05-2004 | NONE | | |
| US 2002064690 | A1 | 30-05-2002 | NONE | | |
| US 6855439 | B1 | 15-02-2005 | US 2005164038 A1 | | 28-07-2005 |
| US 6641936 | B1 | 04-11-2003 | NONE | | |
| US 6620531 | B1 | 16-09-2003 | NONE | | |
| US 6572958 | B1 | 03-06-2003 | NONE | | |
| US 6475611 | B1 | 05-11-2002 | NONE | | |
| US 6403241 | B1 | 11-06-2002 | NONE | | |
| US 6348276 | B1 | 19-02-2002 | NONE | | |
| US 6346339 | B1 | 12-02-2002 | NONE | | |
| US 6117570 | A | 12-09-2000 | NONE | | |
| US 2005095421 | A1 | 05-05-2005 | CN 1614691 A | | 11-05-2005 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 07 25 0678

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2007

| Patent document cited in search report | Publication date | Patent family member(s) | Publication date |
|---|---|---|---|
| US 2005095421 A1 | | JP 2005174531 A<br>SG 111317 A1<br>US 2006051623 A1 | 30-06-2005<br>30-05-2005<br>09-03-2006 |
| US 2004214049 A1 | 28-10-2004 | JP 2004326889 A | 18-11-2004 |
| US 2003219631 A1 | 27-11-2003 | JP 2003338019 A | 28-11-2003 |
| US 2004038083 A1 | 26-02-2004 | CN 1479276 A<br>JP 2004146029 A<br>US 2005227121 A1 | 03-03-2004<br>20-05-2004<br>13-10-2005 |
| EP 1720156 A | 08-11-2006 | CN 1858846 A<br>JP 2006313584 A<br>KR 20060115593 A<br>SG 126890 A1<br>US 2006249371 A1 | 08-11-2006<br>16-11-2006<br>09-11-2006<br>29-11-2006<br>09-11-2006 |
| WO 2005006310 A | 20-01-2005 | NONE | |
| US 2006090998 A1 | 04-05-2006 | JP 2006127637 A | 18-05-2006 |
| US 2006057430 A1 | 16-03-2006 | CN 1767007 A<br>JP 2006079718 A<br>SG 120283 A1 | 03-05-2006<br>23-03-2006<br>28-03-2006 |
| US 2005142388 A1 | 30-06-2005 | CN 1637870 A<br>JP 2005190517 A | 13-07-2005<br>14-07-2005 |
| US 2004110034 A1 | 10-06-2004 | SG 118199 A1 | 27-01-2006 |
| WO 2005093719 A | 06-10-2005 | NONE | |
| US 2004191571 A1 | 30-09-2004 | JP 2004296030 A<br>US 2006134467 A1 | 21-10-2004<br>22-06-2006 |
| US 2002110706 A1 | 15-08-2002 | NONE | |
| US 2002037440 A1 | 28-03-2002 | JP 2002109718 A | 12-04-2002 |
| US 6395634 B1 | 28-05-2002 | SG 83784 A1 | 16-10-2001 |
| US 6383404 B1 | 07-05-2002 | SG 84541 A1 | 20-11-2001 |
| US 2005069730 A1 | 31-03-2005 | CN 1604200 A | 06-04-2005 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 07 25 0678

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2007

| Patent document cited in search report | | Publication date | | Patent family member(s) | | Publication date |
|---|---|---|---|---|---|---|
| | | | JP | 2005108419 A | | 21-04-2005 |
| US 2005069730 | A1 | | SG | 110172 A1 | | 28-04-2005 |
| US 2002146594 | A1 | 10-10-2002 | JP | 3666853 B2 | | 29-06-2005 |
| | | | JP | 2002222518 A | | 09-08-2002 |
| US 6511761 | B1 | 28-01-2003 | JP | 2001184626 A | | 06-07-2001 |